(19) Europäisches Patentamt
European Patent Office
Office européen des brevets

(11) **EP 4 120 357 A1**

(12) **EUROPEAN PATENT APPLICATION**

(43) Date of publication:
**18.01.2023 Bulletin 2023/03**

(21) Application number: **21186114.1**

(22) Date of filing: **16.07.2021**

(51) International Patent Classification (IPC):
**H01L 29/10** $^{(2006.01)}$    **H01L 29/78** $^{(2006.01)}$
**H01L 29/739** $^{(2006.01)}$

(52) Cooperative Patent Classification (CPC):
**H01L 29/7813; H01L 29/1045; H01L 29/1095;
H01L 29/36; H01L 29/42368; H01L 29/66734;
H01L 29/7395; H01L 29/7397; H01L 29/7802**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Hitachi Energy Switzerland AG
5400 Baden (CH)**

(72) Inventors:
• **GUPTA, Gaurav
5600 Aargau (CH)**
• **DE-MICHIELIS, Luca
5000 Aarau (CH)**
• **VITALE, Wolfgang Amadeus
5000 Aarau (CH)**

(74) Representative: **Epping - Hermann - Fischer
Patentanwaltsgesellschaft mbH
Schloßschmidstraße 5
80639 München (DE)**

(54) **POWER SEMICONDUCTOR DEVICE**

(57)    In at least one embodiment, the power semiconductor device (1) comprises:
- a semiconductor body (2) having a source region (21) of a first conductivity type and a well region (22) of a second conductivity type different from the first conductivity type, and the well region (22) comprises a channel region (220) directly at the source region (21), and

- a gate insulator (4) directly between the semiconductor body (2) and the gate electrode (31),
wherein the channel region (220) has a non-uniform channel doping profile (6) along the gate insulator (4), so that a doping concentration $N_A$ in the channel region (220) is largest in a first section (61) remote from the source region (21) .

FIG 2

**Description**

A power semiconductor device is provided.

Document US 6 573 561 B1 refers to a vertical MOSFET with an asymmetrically graded channel profile.

Document US 6 664 594 B2 discloses a power MOS device with an asymmetrical channel structure for enhanced linear operation capability.

Document US 8 067 797 B2 describes a variable threshold trench IGBT with offset emitter contacts.

Embodiments of the disclosure relate to a power semiconductor device that shows improved electrical behavior.

This object is achieved, inter alia, by a power semiconductor device as defined in claim 1. Exemplary further developments constitute the subject-matter of the dependent claims.

In at least one embodiment, the power semiconductor device comprises:

- a semiconductor body having a source region of a first conductivity type and a well region of a second conductivity type different from the first conductivity type, and the well region comprises a channel region starting directly at the source region,
- at least one gate electrode arranged at the semiconductor body and assigned to the at least one channel region, and
- at least one gate insulator directly between the semiconductor body and the at least one assigned gate electrode,

wherein the channel region has an intentionally non-uniform channel doping profile along the gate insulator, so that a doping concentration in the channel region is largest in a first section remote from the source region.

The gate electrode is insulated from the semiconductor body by the gate insulator.

For example, the at least one source region is in direct contact with the assigned gate insulator and/or is directly at the assigned channel region. The first conductivity type is, for example, n-conductive and, thus, the at least one source region is n-doped.

The at least one well region and consequently the at least one channel region are of the second conductivity type different from the first conductivity type. The second conductivity type is, for example, p-conductive and, thus, the at least one channel region is p-doped. It is possible that a maximum doping concentration of the at least one well region and/or of the at least one channel region is less than a maximum doping concentration of the at least one source region.

According to at least one embodiment, the semiconductor body further comprises a drift region which may be of the first conductivity type, too. For example, the drift region is in direct contact with the gate insulator and/or is directly at the channel region. The drift region may be located between the channel region and a drain region or a collector region of the semiconductor body, for example, in a direction perpendicular to the top side of the semiconductor body. For example, the optional trench may terminate in the drift region.

As an option, the semiconductor body can comprise an enhancement layer. For example, the enhancement layer is located directly between the well region and the drift region and may have a higher maximum doping concentration than the drift region. The enhancement layer can also be of the first conductivity type.

According to at least one embodiment, the power semiconductor device is a metal-insulator-semiconductor field-effect transistor, MISFET, a metal-oxide-semiconductor field-effect transistor, MOSFET, or an insulated-gate bipolar transistor, IGBT or a reverse-conducting insulated-gate bipolar transistor, RC-IGBT.

According to at least one embodiment, the well region extends from the top side of the semiconductor body to the drift region. The channel region is part of the well region and may have the same doping concentration. During operation, the electrons flow in the channel region from the source region to the drift region along the gate insulator. The channel region has a thickness in a direction perpendicular to an interface between the gate insulator and the well region, for example, in a nanometer range, exemplarily 1 nm to 50 nm.

For example, the semiconductor body is of Silicon, Si for short. However, the semiconductor body can alternatively be of a wide-bandgap semiconductor material like SiC, $Ga_2O_3$ or GaN.

The gate insulator is made of any insulating material, which may be an oxide. For example, the gate insulator may be of at least one of the following materials: $SiO_2$, $Si_3N_4$, $Al_2O_3$, $Y_2O_3$, $ZrO_2$, $HfO_2$, $La_2O_3$, $Ta_2O_5$, $TiO_2$. Hence, the gate insulator may also be referred to as gate oxide.

According to at least one embodiment, the power semiconductor device is a power device. For example, the power semiconductor device is configured for a maximum voltage of at least 0.2 kV or of at least 0.6 kV or of at least 1.2 kV.

The power semiconductor device is, for example, for a power module in a vehicle to convert direct current from a battery or a fuel cell to alternating current for an electric motor, for example, in hybrid vehicles or plug-in electric vehicles. Moreover, the power semiconductor device can be a fuse, for example, in a vehicle like a car.

For simplification, in the following only one channel region and assigned components are mentioned. If there is a plurality of channel region and assigned components, the features described below may apply to only one, to a plurality or to all of the channel regions and assigned components.

According to at least one embodiment, in the channel region the doping concentration increases monotonically or strictly monotonically along the gate insulator, for example, towards the drift region. Monotonically means that the doping concentration is constant or increases, and strictly monotonically means that the doping concentration continuously increases towards the drift region.

According to at least one embodiment, seen along the gate insulator, the non-uniform channel doping profile has a first section remote from the source region and next to the drift region. The doping concentration is highest in the first section.

Otherwise, the doping concentration is highest in a middle section of the channel region, between the first section and a second section, the second section is close to the assigned source region and remote from the drift region.

If there is no such middle section, then the channel region may consist of the first section having the highest doping concentration and of the second section next to the source region.

According to at least one embodiment, a length of the first section and/or of the middle section is at least 5% or is at least 10% or is at least 15% of an overall length of the channel region along the gate insulator. Alternatively or additionally, said length is at most 40% or at most 30% or at most 25% of said overall length. The same may apply to the second section, if present.

According to at least one embodiment, the doping concentration is constant along the gate insulator in the second section and/or in the middle section. Constant means, for example, that there is no intentional variation of the doping concentration so that variations due to manufacturing tolerances may be disregarded. For example, constant may mean that there are no changes in the doping concentration in the second section and/or in the middle section exceeding 5% or exceeding 10% or exceeding 15% of the maximum doping concentration present in the channel region.

According to at least one embodiment, the doping concentration varies along the channel region by at least 50% or by at least 65% or by at least 80% of the maximum doping concentration of the non-uniform channel doping profile. For example, the second section has a maximum doping concentration of at most 50% or of at most 35% or of at most 20% of the maximum doping concentration of the first section or, if the maximum doping concentration is in the middle section, of the middle section.

According to at least one embodiment, the channel doping profile is configured in a stepped manner so that there is one or a plurality of steps in the channel doping profile along the gate insulator within the channel region. Otherwise, the channel doping profile along the gate insulator may change in a continuous, step-less manner.

According to at least one embodiment, the gate electrode is partially or completely arranged in at least one trench formed in the semiconductor body. The at least one trench and, thus, the assigned gate electrode extends through the well region into the drift region, for example, in a direction away from a top side of the semiconductor body. Consequently, the gate insulator is located partially or completely in the assigned trench, too. Hence, the power semiconductor device could be a trench-based device.

Otherwise, the gate electrode and the gate insulator are applied on the top side of the semiconductor body. Thus, the top side may be a planar face.

According to at least one embodiment, the well region is of multi-layer fashion so that the well region comprises at least two sub-layers. For example, the sub-layers may be grown epitaxially or may be produced by ion implantation and/or thermal treatment. It is possible that the sub-layers are of the same material, but differ in their doping concentrations. Hence, between the sub-layers there may be distinct jumps in the doping concentration and within the respective sub-layer the doping concentration can be constant, for example, with a tolerance of at most 5% of a maximum doping concentration of the respective layer. For example, in at least some planes in parallel with the top side, in this case it is possible that a doping concentration is constant throughout the well region. In other words, there may be an intentional doping gradient only along a depth of the well region, but not in lateral directions in parallel with the top side.

Otherwise, the well region is of single-layer fashion and comprises only one layer in which the doping profile is established. Such a doping profile may be of a continuous fashion without steps and may be produced, for example, by means of ion implantation and/or thermal treatment.

If there is a plurality of sub-layers, the sub-layers may be made by applying different dopants and/or may be grown in different epitaxial growth steps with the respective doping concentration applied during epitaxial growth. The applying of dopants may be made in a single step or by more than one applying step, for example, by using different implantation energies or different dopants. For planar devices, a mask may be used for applying the dopants to achieve the non-uniform channel doping profile. A thermal treatment step may follow after applying dopants or after epitaxial growth.

According to at least one embodiment, outside the channel region and along a depth of the well region, that is, perpendicular to the top side, the well region has a constant doping concentration at least in places. Hence, along at least some vertical intersections the doping concentration may be constant in the well region. Hence, in the well region the non-uniform channel doping profile may be limited to a region next to the gate insulator. For example, the non-uniform channel doping profile is limited to the channel region, for example, with a tolerance of at most 0.5 $\mu$m.

According to at least one embodiment, the gate insulator has a non-uniform thickness along the channel region. For example, along the channel region the gate insulator is thickest in the first section.

According to at least one embodiment, the gate electrode has a non-uniform gate electrode work function profile along the channel region, such that a threshold voltage of the gate electrode is highest in the first section. Hence, a work function $\Phi_m$ of the gate electrode in the first section remote from the source region is largest for n-channel devices and smallest for p-channel devices.

According to at least one embodiment, the gate insulator has a non-uniform gate insulator thickness profile along the channel region. In other words, a thickness of the gate insulator varies along the channel region. Said thickness variation may be continuous or non-continuous, that is, stepped. For example, along the channel region, the gate insulator is thickest in the first section, and consequently may be thinnest in the second section.

According to at least one embodiment, the gate insulator has a non-uniform gate dielectric constant profile along the channel region, such that a relative dielectric constant of the gate insulator is lowest in the first part of the channel region remote from the source region.

According to at least one embodiment, there is the non-uniform thickness profile as well as the non-uniform channel doping profile and/or the non-uniform gate electrode work function profile and/or the non-uniform gate dielectric constant profile. That is, the non-uniform channel doping profile profile can be combined with the non-uniform gate insulator thickness, the non-uniform gate electrode work function profile or the non-uniform gate dielectric constant profile, or with two of the non-uniform channel doping profile, the non-uniform gate electrode work function profile and the non-uniform gate dielectric constant profile, or with all three other non-uniform profiles.

According to at least one embodiment, the power semiconductor device is configured so that both a saturation current and a short-circuit current are decreased, for example, while a collector-emitter saturation voltage $V_{ce\text{-}sat}$, and consequently on-state losses, may remain unaffected. This may be true because of the non-uniform channel doping profile, and compared with an analogously set-up reference semiconductor device but having a uniform doping profile with the same integral doping concentration as the non-uniform channel doping profile of a channel region along a gate insulator.

A power semiconductor device is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:

Figure 1  is a schematic sectional view of a reference semiconductor device,

Figure 2  is a schematic sectional view of an exemplary embodiment of a power semiconductor device described herein,

Figure 3  is a top view of the power semiconductor device of Figure 2,

Figures 4 to 7  are schematic representations of electric data of power semiconductor devices described herein and of a reference semiconductor device,

Figure 8  is a schematic representation of doping profiles of power semiconductor devices described herein and of a reference semiconductor device,

Figure 9  shows simulation results of electric data of power semiconductor devices described herein and of a reference semiconductor device, and

Figures 10 to 16  are schematic sectional views of exemplary embodiments of power semiconductor devices described herein.

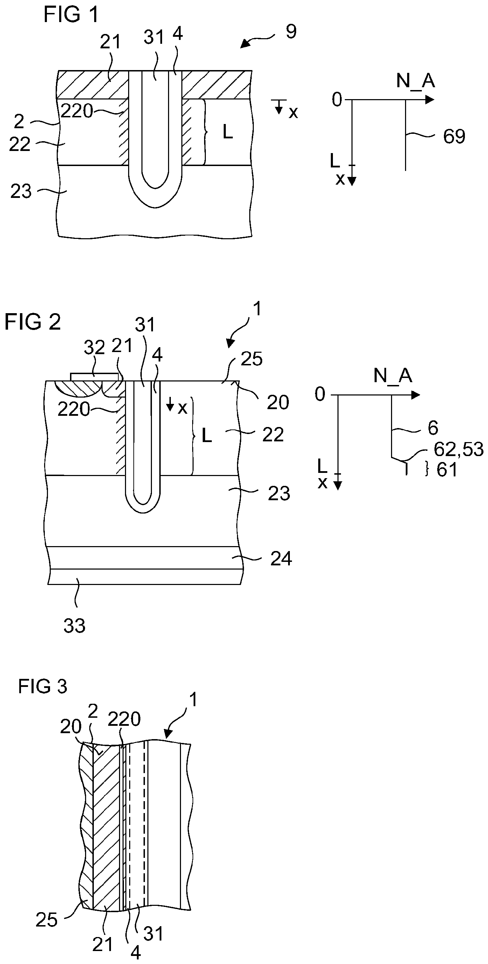

Figure 1 illustrates a reference semiconductor device 9 that corresponds to exemplary embodiments of power semiconductor devices 1 described herein except for a channel doping profile 6, 69 in a channel region 220 included in a well region 22. Like the power semiconductor devices 1, the reference semiconductor device 9 comprises a semiconductor body 2 which is, for example, of Si.

The semiconductor body 2 also comprises a source region 21 at a top side 20 of the semiconductor body 2. A trench passes both through the well region 22 and through the source region 21. The source region 21 is of a first conductivity type, like n-conducting, and the well region 22, and consequently the channel region 220 included by the well region 22, is of a second, different conductivity type, like p-conducting. In the trench, there is a gate electrode 31 that is separated from the semiconductor body 2 by means of an electrically insulating gate insulator 4. The trench and, hence, the gate electrode 31 end in a drift region 23 of the semiconductor body 2. The drift region 23 is of the first conductivity type, too.

In the reference semiconductor device 9, the channel region 220 is doped with a uniform reference doping profile 69. That is, along a direction x away from the source region 21 and towards the drift region 23, there is a constant doping concentration $N_A$. For example, next to the gate insulator 4 where the source region 21 and the channel region 220 are in direct contact, x = 0. For example, next to the gate insulator 4 where the channel region 220 and the drift region 23 are in direct contact, x = L. That is, L corresponds to a channel length of the channel region 220. For example, x runs perpendicular to the top side 20 of the semiconductor layer body 2. Hence, the length L may correspond to a distance between the source region 21 and the drift region 23 directly at the gate insulator 4. Hence, the length L may be defined as the length of the second conductivity type layer between the layers of the first conductivity type, that is, the source region 21 and the drift region 23, wherein the drift region 23 may comprise an enhancement layer of higher doping concentration and a layer of lower doping concentration, not illustrated.

It is noted that a shape of the channel region 220 is drawn only very schematically, and for simplification of the drawings only along one side of the gate electrode 31.

According to the exemplary embodiment of the power semiconductor device 1 as illustrated in Figures 2 and 3, the well region comprises a non-uniform channel doping profile 6, which may be present in the whole well region 22 or which may be limited to the channel region 220 or to the channel region 220 and to an adjacent region of the well region 22. Thus, the doping concentration $N_A$ changes in a stepped manner so that the doping profile 6 has a step 53. The step 53 does not need to exactly follow a theta function or unit step function, but there can be a transitional section 62. Compared to the channel length L, a length of the transitional section 62 is small and amount, for example, to at most 2% or to at most 5% of the channel length L.

Consequently, the doping concentration $N_A$ is highest next to the drift region 23 in a first section 61 of the doping profile 6. A length of the first section 61 is, for example, a quarter or a third of the channel length L. For example, the length of the first section 61 is between 20% and 40% of the channel length L. The amount of change of the doping concentration $N_A$ at the step 53 is illustrated only schematically in Figure 2.

For example, a maximum doping concentration $N_A$ in the first section 61 exceeds a maximum doping concentration $N_A$ in a remainder of the channel region 220, that is, in a second section 64 out of the first section 61 and out of the transitional section 62, by at least a factor 2 or by at least a factor of 5 and/or by at most a factor of 10 or by at most a factor of 8. In the second section 64, the doping concentration $N_A$ may virtually be constant. Both the source region 21 and the well region 22 may be electrically connected by means of at least one source electrode 32 which is located at the top side 20.

As an option, to electrically contact the channel region 220, there can be at least one plug 25 at the top side 20 of the semiconductor body 2. The plug 25 may have a different thickness than the well region 22 so that the plug 25 can extend deeper or shallower into the semiconductor body 2 than the well region 22. Further, the thicknesses of the source region 21 and of the plug 25 can be the same or can be different.

Both the source region 21 and the at least one plug 25 may be electrically connected by means of the at least one source electrode 32 which is located at the top side 20. Exemplarily, the plug 25 has a higher maximum doping concentration than the well region 22 or the channel region 220. The depth of the plug may be lower, deeper or the same as of the well region/channel region.

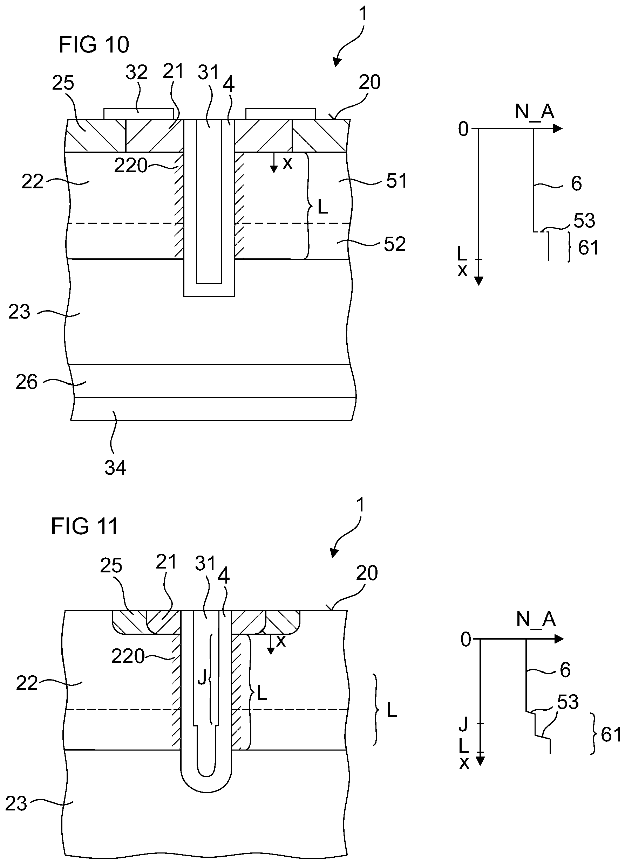

In Figures 2 and 3, the source region 21 and the optional at least one plug 25 are located along only one side of the gate electrode 31. However, the source region 21 and the optional at least one plug 25 can also be arranged along both sides of the gate electrode 31, compare, for example, Figure 10, or all around the gate electrode 31.

For example, the power semiconductor device 1 is an insulated-gate bipolar transistor, IGBT for short. Hence, at as side of the drift region 23 remote from the well region 22, there is a collector region 26 which is of the second conductivity type, too. At the collector region 26, there is a collector electrode 34. Additionally, as a further option there can be a buffer region of the first conductivity type between the drift region 23 and the collector region 26. The doping concentration of such a buffer region, not shown, can be higher than that of the drift region 26.

Seen in top view of the top side 20, the trench accommodating the gate electrode 31 and the gate insulator 4 may be of extended fashion. The source region 21, the at least one plug 25 as well as the channel region 220 may be arranged symmetrically on both sides of the trench, see Figure 3.

For example, maximum doping concentrations of the source regions 21, the collector region 26 or instead of a drain region 24 and the at least one plug 25 are at least $1 \times 10^{18}$ cm$^{-3}$ or at least $5 \times 10^{18}$ cm$^{-3}$ or at least $1 \times 10^{19}$ cm$^{-3}$ and/or at most $5 \times 10^{20}$ cm$^{-3}$ or at most $2 \times 10^{20}$ cm$^{-3}$ or at most $1 \times 10^{20}$ cm$^{-3}$. Further, a maximum doping concentration of the well region 22 and, thus, of the channel region 220 may be at least $5 \times 10^{16}$ cm$^{-3}$ or at least $1 \times 10^{17}$ cm$^{-3}$ and/or at most $5 \times 10^{19}$ cm$^{-3}$ or at most $5 \times 10^{18}$ cm$^{-3}$. For example, the maximum doping concentration in the first section 61 is at least at least $1.5 \times 10^{17}$ cm$^{-3}$ and/or is at most $3 \times 10^{18}$ cm$^{-3}$. For example, the maximum doping concentration present in the non-uniform channel doping profile 6 is at least at least $5 \times 10^{16}$ cm$^{-3}$ and at most $3 \times 10^{18}$ cm$^{-3}$ and/or a minimum doping concentration present in the non-uniform channel doping profile 6 is at most $2 \times 10^{17}$ cm$^{-3}$ or at most $1 \times 10^{17}$ cm$^{-3}$.

Depending on the voltage class of the power semiconductor device 1, a maximum doping concentration of the drift region 23 may be at least $1 \times 10^{11}$ cm$^{-3}$ or at least $1 \times 10^{12}$ cm$^{-3}$ or at least $1 \times 10^{13}$ cm$^{-3}$ and/or at most $1 \times 10^{17}$ cm$^{-3}$ or at most $5 \times 10^{16}$ cm$^{-3}$ or at most $1 \times 10^{16}$ cm$^{-3}$.

Otherwise, the same as to Figure 1 may also apply to Figures 2 and 3.

The concept behind the channel region 220 having the non-uniform channel doping profile 6 is explained in the following.

For a power semiconductor device 1, exemplarily for low frequency applications, it may be desirable to have on-state losses as low as possible in order to minimize the total electrical losses. Further, from a device reliability point of view, it may be advantageous to have a low short circuit current. Thus, a power semiconductor device 1 with minimized on-state losses and improved short circuit capability may be desired.

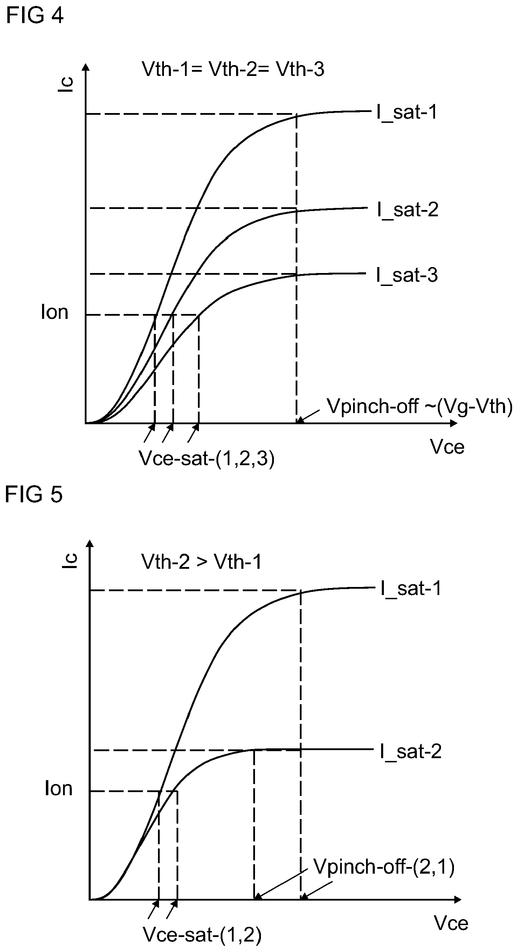

However, some means to lower an on-state voltage drop $V_{ce-sat}$, for example, by reducing the channel length L or increasing channel width W, often result in an undesired higher saturation current $I_{sat}$, as illustrated schematically using output characteristics $I_c$ vs. $V_{ce}$, see Figure 4. The higher $I_{sat}$ is directly related to a higher short circuit current $I_{SC}$, adversely affecting the short circuit capability of the power semiconductor device 1. On the other hand, raising a threshold voltage $V_{th}$ of the power semiconductor device 1 in order to lower $I_{sat}$, for example, by increasing a channel doping concentration, results in higher $V_{ce-sat}$ as illustrated in Figure 5. Thus, Figures 4 and 5 are schematics of typical output characteristics of an IGBT with a uniform threshold profile along the whole channel region, in Figure 4 for a same $V_{th}$ and different channel resistance, and in Figure 5 for different threshold voltages $V_{th}$.

Other techniques to reduce the short-circuit current such as:

a) increasing the channel length L,
b) reducing an anode injection efficiency, by reducing an anode implant dose,
c) reducing a channel width, by decreasing a source coverage along the trench, and
d) reducing the channel width, by increasing a cell pitch, also undesirably result in higher on-state losses. Moreover, techniques such as d) can also adversely affect the breakdown capability of the power semiconductor device 1. Reducing gate biasing in order to reduce short-circuit current may also not be desirable as it leads to unstable dynamic behavior and moreover it is mainly defined by the application requirements.

Thus, there is a trade-off between minimizing the on-state losses and decreasing the short circuit current in a conventional MISFET or IGBT device. For an application requiring improved short circuit capability, it may be desirable to be able to decrease the short circuit current $I_{SC}$ without affecting $V_{ce-sat}$.

With the power semiconductor device 1 described herein, the trade-off between on-state losses and short circuit current is improved by improving the latter without adversely affecting the former. Differently from other approaches, the described design features a non-uniform threshold voltage profile along the channel region 220 next to the gate insulator 4 to lower down the saturation current for a given $V_{ce-sat}$. The proposed non-uniform $V_{th}$ in the power semiconductor device 1 described herein is achieved by implementing the non-uniform channel doping profile 6 in the channel region 220. The described power semiconductor device 1 does not adversely affect the breakdown capability and more so ever the turn-off losses of the power semiconductor device 1. In addition, the described concept is applicable to any MOS device in general such as power-MOSFET or IGBT or reverse-conducting-IGBT and is even compatible with both planar and trench architectures.

With the power semiconductor device 1 described herein, an improved MISFET, MOSFET or IGBT or RC-IGBT device with an enhanced short circuit capability is introduced without a detrimental effect on the on-state losses. The improved design also relaxes the design constraints of the IGBT, enabling the possibility to independently explore the other methods mentioned above to minimize the on-state losses which are normally limited by the short circuit capability of the respective device.

In the following, some theoretical background to the idea of the semiconductor device 1 described herein is presented.

For a reference long channel MOS device, it is known that a channel pinch-off at high $V_{ce}$ is responsible for the current saturation in the output characteristics, which ultimately determines the short circuit current. The channel pinch-off voltage $V_{pinch-off}$ is determined by the threshold voltage $V_{th}$. Exemplarily, the channel starts pinching-off near its drain end, at x = L where L is the channel length, when the applied bias $V_{ce}$ exceeds the pinch-off voltage $V_{pinch-off} \approx (V_g - V_{th})$, where $V_g$ is the applied gate voltage. At such applied $V_{ce}$, the voltage drop perpendicular to the channel is less than $V_{th}$ and therefore the channel cannot sustain any longer near the drain end.

However, for a more detailed understanding of the device, it should be considered that the channel pinch-off, however, is more of a local phenomenon, taking place specifically near the drain end of the channel. Therefore, more correctly, it is the local threshold voltage, $V_{th}(x)$, which determines the pinch-off point and, thus, the saturation current. This implies that it is possible to lower the $V_{pinch-off}$ by locally increasing $V_{th}(L)$ at the channel end, that is, in the first section 61 near the drift region 23.

Further, in order to keep the overall channel resistance and thereby $V_{ce-sat}$ unaffected, $V_{th}(x)$ can be decreased in the rest of the channel.

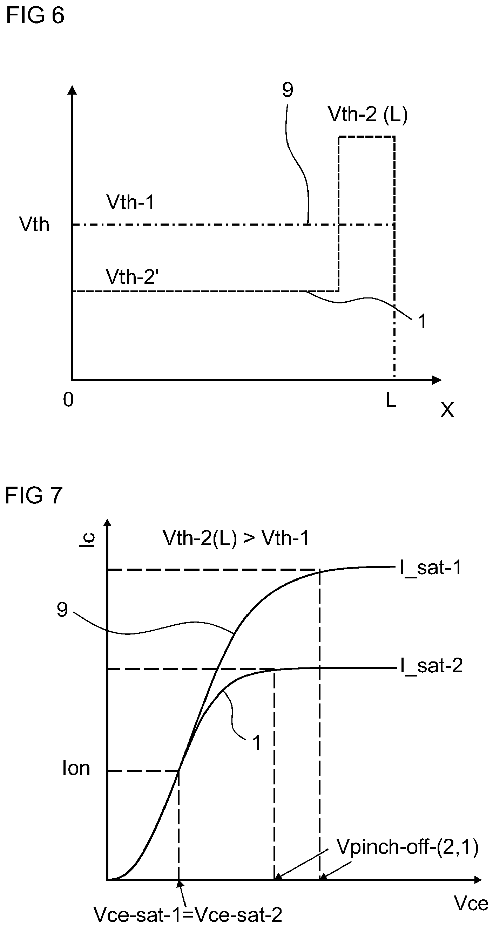

This is illustrated schematically in Figure 6 where the curve referring to the reference semiconductor device 9 comprises a uniform threshold voltage $V_{th-1}$ profile along the whole channel. The curve for the power semiconductor device 1 on the other hand consists of a non-uniform $V_{th}$ profile along the channel, where $V_{th}$ is locally raised near the channel end, that is, in the first section 61, such that $V_{th-2}(L) > V_{th-1}$ in order to lower the pinch-off point, while $V_{th-2}' < V_{th-1}$ in the rest of the channel to keep the overall channel resistance the same. In this way, a saturation current and thereby a short circuit current can be significantly reduced without affecting the on-state losses as illustrated in the schematic output in Figure 7. Local $V_{th}$ variation thus holds the key for improved short circuit capability of a MISFET or MOSFET or an IGBT device.

$V_{th}$ of the channel is a function of various other MOS cell design parameters as indicated in below equation:

$$V_t = V_{fb} + 2\Phi_B + \frac{\sqrt{qN_A 2\varepsilon_S 2\Phi_B}}{C_{ox}}$$

where $V_t$ is the threshold voltage, $V_{fb}$ is the flatband voltage, $V_{fb} = (\phi_m - \phi_S)$ where $\phi_m$ and $\phi_S$ are the gate metal and the semiconductor work function, respectively. $N_A$ is the channel body doping, $\varepsilon_S$ is the permittivity of the semiconductor, $C_{OX}$ is the gate insulator capacitance, and $\phi_B$ is the semiconductor surface potential and:

$$\Phi_B = kt \ln \frac{N_A}{n_i}$$

where k is the Boltzmann constant, T is the temperature and $n_i$ is the intrinsic carrier concentration of the semiconductor.

Therefore, the required non-uniform $V_{th}$ profile across the channel with relatively higher $V_{th}$ in the first section 61 can be achieved by introducing a non-uniformity in one or in any combination of the following MOS design parameters:

1. channel doping profile, $N_A$ (x), as detailed herein,
2. gate oxide thickness, Tox (x),
3. gate dielectric, $\varepsilon_{OX}$ (y), and/or
4. gate metal work function, $\phi_m$ (x), since $V_{fb} = (\phi_m - \phi_S)$.

In the following, the focus is on the channel doping profile variation, but said doping concentration variation can of course be combined with a varying gate insulator thickness, a varying gate dielectric and/or a varying gate metal work function.

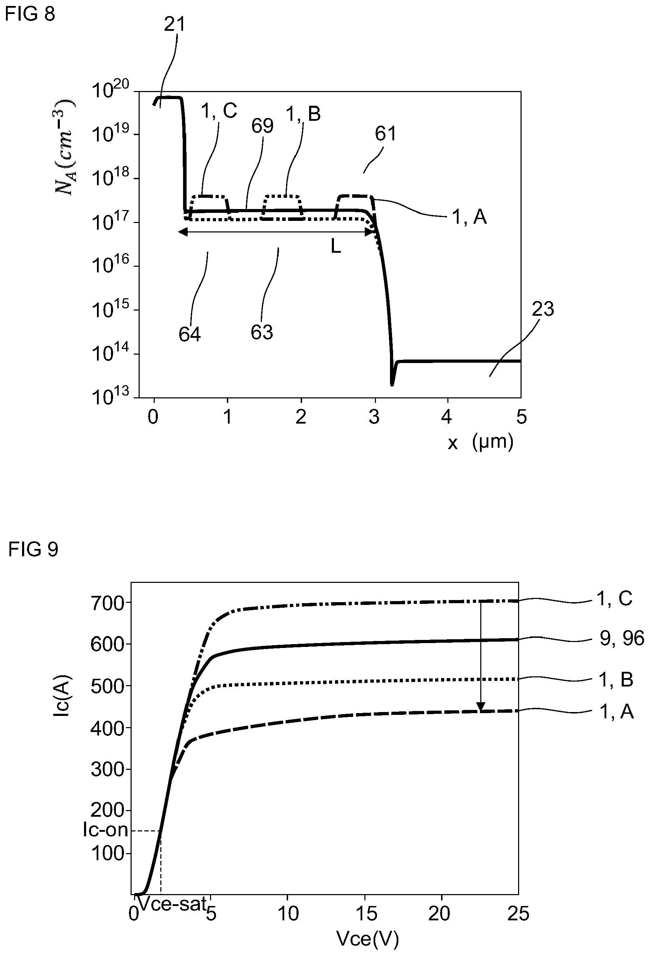

Figures 1 and 2 above show schematic cross-sections of the reference semiconductor device 9 with a uniform doping profile 69 and of the power semiconductor device 1 with the non-uniform channel doping profile 6 as implemented in the simulations presented below. Three different doping profiles A, B, C were investigated, see Figure 8.

That is, the non-uniform channel doping profiles $N_A$ (x) have been implemented in technology computer aided design, TCAD, simulations to obtain the locally varying $V_{th}$ profile with the aim of reducing the saturation current without affecting the on-state performance. In these designs A, B, C boron concentration $N_A$ (x) along the channel region 220 was varied such that its peak position is shifted from top, x = 0, to bottom, x = L, of the channel region 220 as shown in Figure 8. For comparison, the uniform doping profile 69 of the reference semiconductor device 9 is illustrated, too. For all these four designs A, B, C, 69, the total integral doping concentration along the channel was however kept same in order to maintain the identical $V_{ce-sat}$.

The output characteristics, see Figure 9, show the expected effect which is attributed to the local $V_{th}$ variation due to non-uniform channel doping profiles 6. The design with boron peak in the first section 61 of the channel region 220, that is, design A, shows reduced $I_{sat}$ as compared to that of design C with a peak doping concentration in a second section 64 next to the source region 21. Design A is also better compared to the reference uniform doping profile 69 for the same reason, that is, due to higher local $V_{th}$ at the channel region end. Further, it is noted that design C may be undesired for applications where short circuit current needs to be reduced. The short circuit problem, that is, to reduce the current between the source and the collector, has been solved in the power semiconductor devices 1 described herein by introducing the non-uniform channel doping profile 6 with higher doping near the channel end, that is, with higher doping concentrations in the middle section 63 or in the first section 61 next to the drain region as in designs B and A.

The overall channel resistance is kept the same by lowering the doping in the other part of the channel which fixes the $V_{ce-sat}$. In design B, the peak doping concentration in a middle section 63 between the second section 64 and the first section 61, and $I_{sat}$ is already reduced compared with the reference semiconductor device 9.

The breakdown characteristics of the device remain unaffected by having the non-uniform channel doping profile 6. Switching losses $E_{off}$ remain largely unaffected by having the non-uniform channel doping profile 6, compare the list below that summarizes the simulation results for designs A, B and C with the different doping profiles as illustrated in Figure 8.

Design C of the semiconductor device with the doping peak in the first section 64 next to the source region 21:

- $V_{ce-sat}$ at 150 A: 1.667 V;
- $V_{th}$ at 10 mA: 7.12 V;
- $E_{off}$: 13.76 mJ;
- $I_{SC}$ := 100%.

Design B of the exemplarily power semiconductor device 1 with the doping peak in the middle section 63:

- $V_{ce\text{-}sat}$ at 150 A: 1.676 V;
- $V_{th}$ at 10 mA: 7.12 V;
- $E_{off}$: 13.58 mJ;
- $I_{SC}$ := about 73% of Isc of design C.

Design A of the exemplarily power semiconductor device 1 with the doping peak in the first section 61:

- $V_{ce\text{-}sat}$ at 150 A: 1.688 V;
- $V_{th}$ at 10 mA: 7.08 V;
- $E_{off}$: 13.72 mJ;
- $I_{SC}$ := about 62% of Isc of design C.

For example, the length L of the channel is in each case between 1 μm and 10 μm or between 1 μm and 5 μm. In the exemplary devices 9, A, B, C, the length L of the channel is in each case 2.5 μm, and the first section 61 in design A has a length of 0.5 μm.

In the exemplary embodiment of the power semiconductor device 1 of Figure 10, the doping profile 6 again has the one step 53. Because optionally the channel region 220 is produced, for example, grown, with a first sub-layer 51 and a second sub-layer 52 which can be doped, for example, during growth, there is virtually no transitional region in this exemplary embodiment.

It is possible in all other exemplary embodiments, that the trench accommodating the gate electrode 31 does not need to have a round end part in the drift region 23, but can be of rectangular shape, or also of other shapes, when seen in cross-section, compare Figure 10, too.

As it is possible in all other exemplary embodiments of the power semiconductor device 1, an outward side of the gate insulator 4 facing the semiconductor body 2 may be of planar fashion, at least along the channel region 220.

Moreover, it is illustrated that the power semiconductor device 1 of Figure 10 is not an IGBT, but a MISFET or MOSFET. Consequently, the power semiconductor device 1 comprises a drain region 24 instead of the collector region 26. Hence, at as side of the drift region 23 remote from the well region 22, there is the drain region 24 which is of the first conductivity type, too, but, for example, with a maximum doping concentration higher than in the drift region 23. At the drain region 24, there is a drain electrode 33.

Of course, all the gate insulator designs of the IGBT power semiconductor devices 1 can apply for the MOSFET and MISFET power semiconductor device 1, and vice versa.

Otherwise, the same as to Figures 2 to 9 may also apply to Figure 10, and vice versa.

According to Figure 11, the doping profile 6 comprises a plurality of the steps 53, for example, two of the steps 53. For example, the second step closer to the drift region 23 is larger than the first step closer to the source region 21. The first step may define the beginning of the first section 61.

As an option, the non-uniform channel doping profile 6 can be combined with a varying thickness of the gate insulator 4. For example, in a first section along the channel region out of the end part the thickness of the gate insulator 4 is between 20 nm and 80 nm inclusive or is between 40 nm and 80 nm inclusive.

As in all other exemplary embodiments, these two ideas, that is, having an asymmetric, non-uniform gate insulator thickness and the non-uniform channel doping profile 6, can be combined with each other. In this case the gate insulator 4 may be thickest in the first section 61. The thickness of the gate insulator 61 may increase in the same manner as the doping concentration $N_A$, or in a different manner. Hence, the schematic progressions of the non-uniform channel doping profiles 6 described herein can apply to the non-uniform gate insulator thickness, too, wherein the progressions of the non-uniform channel doping profiles 6 and the non-uniform gate insulator thickness can be the same or can be different.

Alternatively or additionally, in a section next to the drift region 23 and, thus, in the first section 61 said thickness could be between 120 nm and 250 nm inclusive or between 120 nm and 180 nm inclusive. For example, these two thicknesses of the gate insulator 4 differ by at least a factor of 1.5 and/or by at most a factor of 5. A position J of a gate insulator thickness jump is, for example, within the first section 61. For example, said position J is between the two steps 53 in the doping profile 6.

Otherwise, the same as to Figures 2 to 10 may also apply to Figure 11, and vice versa.

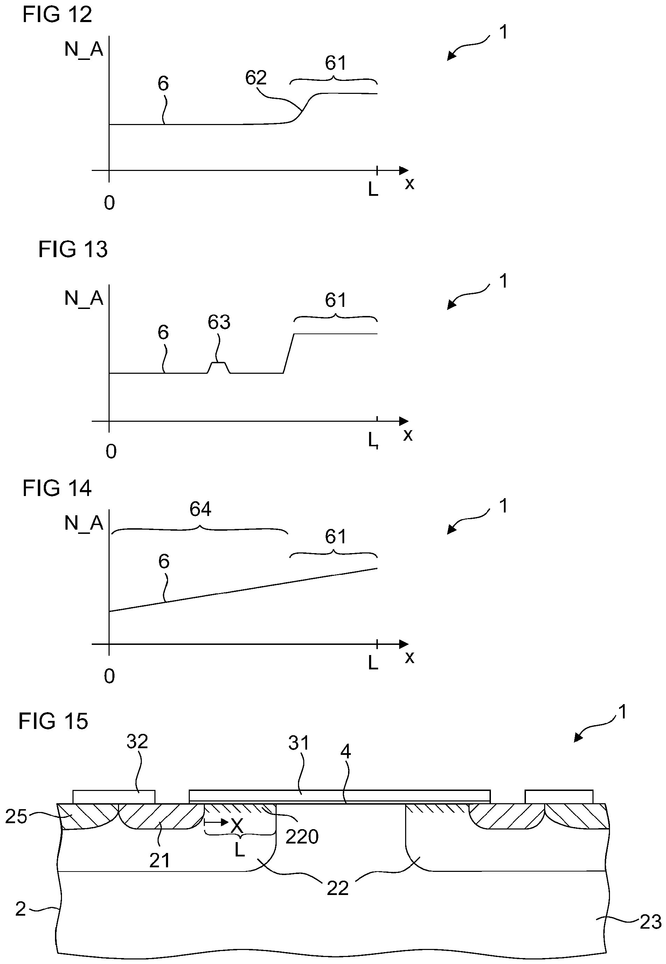

In Figure 12, it is illustrated that the doping concentration $N_A$ is not fashioned in a stepped manner, but changes continuously at a beginning of the first section 61. The transitional section 62, in which the doping concentration $N_A$ changes, amounts, for example, to at least 2% and/or to at most 15% or to at most 10% or to at most 5% of the length L. Similar to Figure 11, there may be more than one such transitional section 61.

Otherwise, the same as to Figures 2 to 11 may also apply to Figure 12, and vice versa.

According to Figure 13, the doping concentration $N_A$ does not increase monotonically. Thus, there can be a minor first step to higher doping concentrations $N_A$ near the source region 21 and a minor second step back to the original doping concentration $N_A$, and there is a major third step to a higher, final and maximum doping concentration $N_A$ next to the drift region 23. The minor peak in the doping concentration $N_A$ may be located in the middle section 63.

Otherwise, the same as to Figures 2 to 12 may also apply to Figure 13, and vice versa.

In the exemplary embodiment of Figure 14, the doping concentration $N_A$ increases continuously in a linear manner from the second section 64 till the first section 61. Hence, there is no need for a well-defined interface or dividing line between the first section 61 and the second section 64.

Otherwise, the same as to Figures 2 to 13 may also apply to Figure 14, and vice versa.

According to Figure 15, the power semiconductor device 1 is of a planar design and not of a trench design like, for example, the power semiconductor device 1 of Figures 2 and 3. Hence, the top side 20 is planar, and the gate insulator 4 and the gate electrode 31 are applied onto the top side 20. Consequently, the length L between the source region 21 and the drift region 23 is in parallel with the top side 20, and not like in the other exemplary embodiments perpendicular to the top side 20. The same applies to the direction x along which the doping concentration $N_A$ varies.

In Figure 15, the well region 22 protrudes from the source region 21 in a lateral direction, that is, in parallel with the top side 20, and extends below the gate insulator 4. Also the source region 21 may extend below the gate insulator 4, but less far.

All the above-mentioned different designs of the doping profile 6 can analogously be applied to the planar concept of Figure 15, both in case of a MISFET or MOSFET as well in case of an IGBT. Hence, the same as to Figures 2 to 13 can also apply to Figure 14.

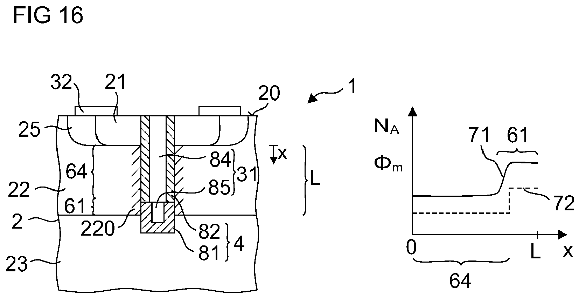

Moreover, in Figure 16 it is illustrated that there is not only the non-uniform channel doping profile, but also a non-uniform gate insulator thickness profile and a non-uniform gate dielectric constant profile of the gate insulator 4 because of optionally present at least two different materials 81, 82, the gate insulator 4 is composed of. That is, the thickness of the gate insulator 4 varies along the channel region 220.

For example, a difference of the relative dielectric constant along the channel region 220 because of the at least two different materials 81, 82 is at least 2.0 or is at least 3.0 or is at least 3.5. Alternatively or additionally, said difference is at most 50 or is at most 25. When comparing the respective relative dielectric constants, text book values for the respective materials at room temperature, that is, 300 K, and at a frequency of a varying electric field of at most 1 kHz may be used.

For example, a thickness of the first material 81 in the first section 61 exceeds a thickness of the second material 82 in the second section 64, or vice versa. For example, a thickness difference between the first material 81 and the second material 82 is at least 20% or at least 40% of a maximum thickness of the gate insulator 4 along the channel region 220. If there is only the non-uniform gate insulator thickness profile and a uniform gate dielectric constant profile, the gate insulator 4 can be of a single material.

For example, a thickness of the gate insulator 4 in the second section 64 is between 50 nm and 100 nm inclusive and/or a thickness of the gate insulator 4 in the first section 61 is between 100 nm and 240 nm inclusive. However, other than illustrated in Figure 16, the thickness of the gate insulator 4 in the first section 61 can alternatively be smaller than in the second section 64, and a maximum thickness can instead be present in the second section 64.

Accordingly, there is a step in the non-uniform channel doping profile 6 at the interface between the first section 61 and the second section 64, see the insert in Figure 16.

Additionally or alternatively to the non-uniform gate dielectric constant profile and/or the non-uniform gate insulator thickness profile, there can be a non-uniform gate electrode work function profile 72. Hence, the gate electrode 31 can include a first gate material 84 next to the source region 21 and a second gate material 85 next to the drain region 23. The gate materials 84, 85 may change where the materials 81, 82 of the gate insulator 4 change. Thus, the work function $\Phi_m$ of the gate electrode 31 in the first section 61 remote from the source region 21 is largest for n-channel devices and smallest for the p-channel devices.

For example, a work function difference of the gate electrode along the channel region 220 is at least 0.7 eV or is at least 1.0 eV or is at least 1.1 eV. This applies, for example, when the gate electrode 31 is based on poly-silicon. If metals like Li, Zn, Hf for a low work function, or metals like Pt, Pd or Au for a high work function are also considered, the work function difference may be at least 1.3 eV or at least 1.4 eV. For example, the work function difference is at most 2.0 eV or at most 1.5 eV.

For example, the second gate material 85 is p$^+$-doped poly-silicon having a work function $\Phi_m$ of about 5.22 eV. For example, the first gate material 84 is n$^+$-doped poly-silicon having a work function $\Phi_m$ of about 4.1 eV. Although based on silicon, these first gate materials 84 and second materials 85 may be referred to as different gate electrode metals.

Such at least one of the non-uniform gate insulator thickness profile, the non-uniform gate insulator dielectric constant profile and the non-uniform gate insulator thickness profile can be present analogously in all the other exemplary embodiments, too.

Otherwise, the same as to Figures 2 to 15 may also apply to Figure 16, and vice versa.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The power semiconductor device described here is not restricted by the description on the basis of the exemplary embodiments. Rather, the power semiconductor device encompasses any new feature and also any combination of features, which includes any combination of features in the patent claims, even if this feature or this combination itself is not explicitly specified in the patent claims or exemplary embodiments.

List of Reference Signs

| | |
|---|---|
| 1 | power semiconductor device |
| 2 | semiconductor body |
| 20 | top side |
| 21 | source region |
| 22 | well region |
| 220 | channel region |
| 23 | drift region |
| 24 | drain region |
| 25 | plug |
| 26 | collector region |
| 31 | gate electrode |
| 32 | source electrode |
| 33 | drain electrode |
| 34 | collector electrode |
| 4 | gate insulator |
| 51 | first sub-layer of the channel region |
| 52 | second sub-layer of the channel region |
| 53 | step in the doping concentration |
| 6 | non-uniform channel doping profile |
| 61 | first section |
| 62 | transitional section |
| 63 | middle section |
| 64 | second section |
| 69 | uniform reference doping profile |
| 72 | non-uniform gate electrode work function profile |
| 81 | first material |
| 82 | second material |
| 84 | first gate material |
| 85 | second gate material |
| 9 | reference semiconductor device |
| A | first exemplary power semiconductor device |
| B | second exemplary power semiconductor device |
| C | third exemplary power semiconductor device |
| J | position of gate insulator thickness jump |
| $I_{sat}$ | saturation current |
| L | length of the channel region along the gate insulator |
| $N_A$ | doping concentration |
| $V_{th}$ | threshold voltage |
| x | length along the channel region |

**Claims**

1. A power semiconductor device (1) comprising:

   - a semiconductor body (2) having a source region (21) of a first conductivity type and a well region (22) of a second conductivity type different from the first conductivity type, and the well region (22) comprises a channel region (220) directly at the source region (21), and

   - a gate insulator (4) directly between the semiconductor body (2) and the gate electrode (31),

   wherein the channel region (220) has a non-uniform channel doping profile (6) along the gate insulator (4), so that a doping concentration $N_A$ in the channel region (220) is largest in a first section (61) remote from the source region (21) .

2. The power semiconductor device (1) according to the preceding claim, wherein:

   - the source region (21) is in direct contact with the gate insulator (4) and the channel region (220),
   - the semiconductor body (2) further comprises a drift region (23) of the first conductivity type in direct contact with the gate insulator (4) and directly at the channel region (220), and
   - the power semiconductor device (1) is a metal-insulator-semiconductor field-effect transistor, MISFET, a metal-oxide-semiconductor field-effect transistor, MOSFET, an insulated-gate bipolar transistor, IGBT, or a reverse-conducting insulated-gate bipolar transistor, RC-IGBT.

3. The power semiconductor device (1) according to the preceding claim,
   wherein, along the gate insulator (4), the doping concentration $N_A$ in the channel region (220) is highest directly at the drift region (23).

4. The power semiconductor device (1) according to any one of the preceding claims,
   wherein the doping concentration $N_A$ increases monotonically or strictly monotonically in the channel region (220) along the gate insulator (4) in a direction away from the source region (21).

5. The power semiconductor device (1) according to the preceding claim,
   wherein a length of the first section (61) is at least 10% and at most 40% of an overall length L of the channel region (220) along the gate insulator (4).

6. The power semiconductor device (1) according to any one of the preceding claims,
   wherein the non-uniform channel doping profile (6) has a second section (64) which extends to the source region (21) along the gate insulator (4), wherein the doping concentration $N_A$ is constant along the gate insulator (4) in the second section (64).

7. The power semiconductor device (1) according to any one of the preceding claims,
   wherein the doping concentration $N_A$ varies along the channel region (220) by at least 50% of a maximum doping concentration of the non-uniform channel doping profile (6).

8. The power semiconductor device (1) according to the preceding claim,
wherein at least one of:

 - the maximum doping concentration of the non-uniform channel doping profile (6) is at least at least $5 \times 10^{16}$ cm$^{-3}$ and at most $3 \times 10^{18}$ cm$^{-3}$, or
 - the minimum doping concentration of the non-uniform channel doping profile (6) is at most $2 \times 10^{17}$ cm$^{-3}$ or at most $1 \times 10^{17}$ cm$^{-3}$.

9. The power semiconductor device (1) according to any one of the preceding claims,
wherein the non-uniform channel doping profile (6) is configured in a stepped manner so that there is at least one step (53) in the non-uniform channel doping profile (6) along the gate insulator (4).

10. The power semiconductor device (1) according to any one of claims 1 to 9,
wherein the doping concentration $N_A$ changes in a continuous, step-less manner along the gate insulator (4).

11. The power semiconductor device (1) according to any one of the preceding claims,
wherein the gate electrode (31) is at least partially arranged in a trench formed in the semiconductor body (2) and through the well region (22).

12. The power semiconductor device (1) according to any one of claims 1 to 10,
wherein the gate electrode (31) and the gate insulator (4) are arranged on a planar top side (20) of the semiconductor body (2).

13. The power semiconductor device (1) according to any one of the preceding claims,
wherein the well region (22) is of multi-layer fashion so that the well region (22) comprises at least two sub-layers (51, 52) having different maximum doping concentrations.

14. The power semiconductor device (1) according to any one of the preceding claims,
wherein outside the channel region (220) and along a depth of the well region (22), the well region (22) has a constant doping concentration at least in places.

15. The power semiconductor device (1) according to any one of the preceding claims,
wherein the gate insulator (4) has a non-uniform thickness along the channel region (220) so that, along the channel region (220), the gate insulator (4) is thickest in the first section (61).

FIG 1

21  31  4

9

2
220

22

23

N_A

0

69

L
x

FIG 2

32  21  31

4

1

25

20

220

22

L
x

23

24

33

N_A

0

6

62,53
61

L
x

FIG 3

20  2  220

1

25

21  4  31

FIG 4

Vth-1= Vth-2= Vth-3

Ic

I_sat-1

I_sat-2

I_sat-3

Ion

Vpinch-off ~(Vg-Vth)

Vce

Vce-sat-(1,2,3)

FIG 5

Vth-2 > Vth-1

Ic

I_sat-1

I_sat-2

Ion

Vpinch-off-(2,1)

Vce

Vce-sat-(1,2)

FIG 6

FIG 7

FIG 8

FIG 9

FIG 10

FIG 11

FIG 12

N_A

6   62   61

0                    L   x

FIG 13

N_A

6   63   61

0                    L   x

FIG 14

N_A

64   61

6

0                    L   x

FIG 15

32   31   4

25

21   220
L

22

2                    23

FIG 16

Europäisches
Patentamt

European
Patent Office

Office européen
des brevets

# EUROPEAN SEARCH REPORT

Application Number

EP 21 18 6114

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/111279 A1 (RYU SEI-HYUNG [US]) 15 April 2021 (2021-04-15) * paragraph [0032] - paragraph [0040]; figures 1, 2A-2D * ----- | 1-3,5-9, 12,13 | INV. H01L29/10 H01L29/78 H01L29/739 |
| X | US 2005/133833 A1 (TSUI BING-YUE [TW]) 23 June 2005 (2005-06-23) * paragraph [0036] - paragraph [0039]; figures 3D, 5 * ----- | 1-4,10, 11 | |
| X | US 2016/064550 A1 (SUGIMOTO MASAHIRO [JP] ET AL) 3 March 2016 (2016-03-03) * paragraph [0016] - paragraph [0035]; figure 1 * * paragraph [0048] - paragraph [0054]; figure 4 * * paragraph [0067]; figure 7 * ----- | 1-3,11, 14,15 | |
| | | | TECHNICAL FIELDS SEARCHED (IPC) H01L |

The present search report has been drawn up for all claims

| Place of search | Date of completion of the search | Examiner |
|---|---|---|
| Munich | 16 December 2021 | Lantier, Roberta |

EPO FORM 1503 03.82 (P04C01)

**EP 4 120 357 A1**

## ANNEX TO THE EUROPEAN SEARCH REPORT
## ON EUROPEAN PATENT APPLICATION NO.

EP 21 18 6114

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2021

| Patent document cited in search report | | Publication date | Patent family member(s) | | Publication date |
|---|---|---|---|---|---|
| US 2021111279 | A1 | 15-04-2021 | US 2021111279 A1 | | 15-04-2021 |
| | | | WO 2021071758 A1 | | 15-04-2021 |
| US 2005133833 | A1 | 23-06-2005 | TW I222685 B | | 21-10-2004 |
| | | | US 2005133833 A1 | | 23-06-2005 |
| | | | US 2007080396 A1 | | 12-04-2007 |
| | | | US 2008009118 A1 | | 10-01-2008 |
| US 2016064550 | A1 | 03-03-2016 | JP 2016054181 A | | 14-04-2016 |
| | | | US 2016064550 A1 | | 03-03-2016 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6573561 B1
- US 6664594 B2
- US 8067797 B2